# EUROPEAN PATENT APPLICATION

(11) **EP 4 756 660 A1**
(43) Date of publication of application: **10.06.2026**
(21) Application number: 24217607.1
(22) Date of filing: 04.12.2024
(51) Int. Cl.: G06F 30/13, G06F 30/18

(54) **DATA FORMAT FOR AN ALIGNMENT FOR A LINEAR CONSTRUCTION INFRASTRUCTURE**

(71) Applicant: Trimble Inc, Westminster CO 80021 (US)
(72) Inventor: Luanwuttipong, Wanlop, 1337 Sandvika (NO)
(74) Representative: Fennell, Gareth Charles

(57) **Abstract**

A data format embodied on a medium, wherein the data format defines an alignment for a linear construction infrastructure, wherein the data format comprises a series of points, each point defining a position on the alignment, wherein each point comprises: (i) a horizontal geographic coordinate of the point; (ii) a chainage number of the alignment at the point; and (iii) a horizontal direction of the alignment at the point.

## Description

### TECHNICAL FIELD

The present disclosure relates to systems and methods for providing coordinate reference systems and linear referencing systems.

### BACKGROUND

In the field of construction, and particularly construction of linear infrastructure such as new roads, train tracks, waterways and the like, a conversion must be made between the dimensions and location of a designed structure and real-word coordinates. Such a conversion allows accurate placement of the linear infrastructure according to its design.

Typically, this is performed by producing a local coordinate system for the construction which can be directly mapped to both the design or plans of the construction project, and a global coordinate system.

In construction of linear projects, a so-called 'linear referencing system' is typically used as a local referencing system. Such a system typically sets out a linear reference line for linear construction infrastructure. The linear reference line may, for example, define the centreline of a planned road. 'Linear' in this context will be understood in the context of progressing in a sequential manner.

Such a linear reference line will typically describe the shape of such a road by setting out the path of the centreline of the road through the surrounding landscape.

### SUMMARY

In overview, the present disclosure provides a data format embodied on a medium such as a computer-readable memory, wherein the data format defines an alignment for a linear construction infrastructure, such as a road or train track. The data format comprises a series of points, each point defining a position on the alignment, wherein each point comprises: a horizontal geographic coordinate of the point; a chainage number of the alignment at the point; and a horizontal direction of the alignment at the point.

Aspects of the present disclosure of the present application are set out in the independent claims. Other aspects of the present disclosure will be appreciated from the following description.

### BRIEF DESCRIPTION OF THE DRAWINGS

Embodiments of the present disclosure will now be described, by way of example only, with reference to the accompanying drawings, in which:
Fig. 1a shows an example of a horizontal component of an alignment;
Fig. 1b shows an example of a vertical component of an alignment;
Fig. 2 shows an example of a three-dimensional representation of an alignment;
Fig. 3 shows an example process of computing the location of a construction element in accordance with the prior art;
Fig. 4 shows an example of the process of Fig. 3;
Fig. 5 shows an example process of computing the location of a construction element in accordance with the present disclosure;
Fig. 6 shows a series of points in their corresponding horizontal locations according to an alignment;
Fig. 7 shows a model created in accordance with the alignment of Fig 1a, Fig. 1b and Fig. 2;
Fig 8 shows a first computing device and a second computing device in communication with a network, configured to perform a method in accordance with the present disclosure;
Fig. 9a shows a construction machine configured to perform a method in accordance with the present disclosure;
Fig. 9b shows a control system configured to control the construction machine of

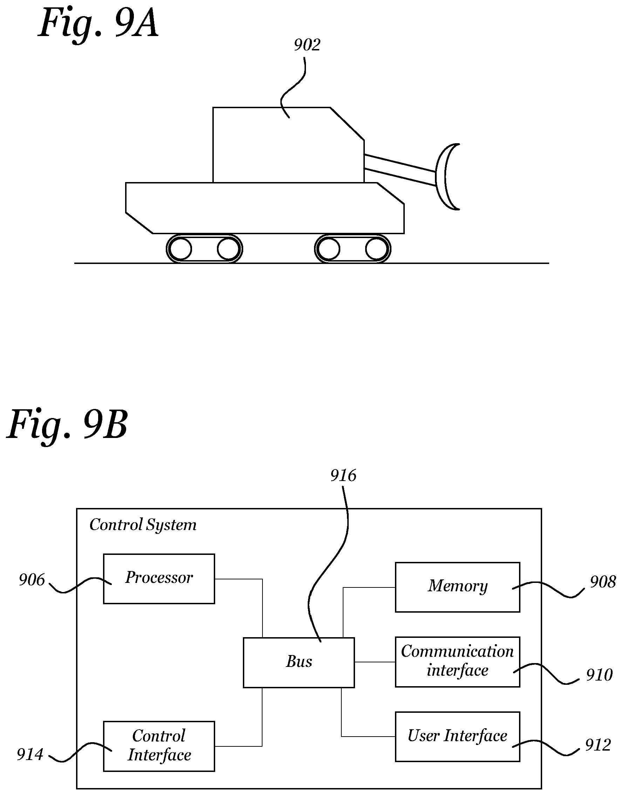

Fig. 9a to perform a method in accordance with the present disclosure; and

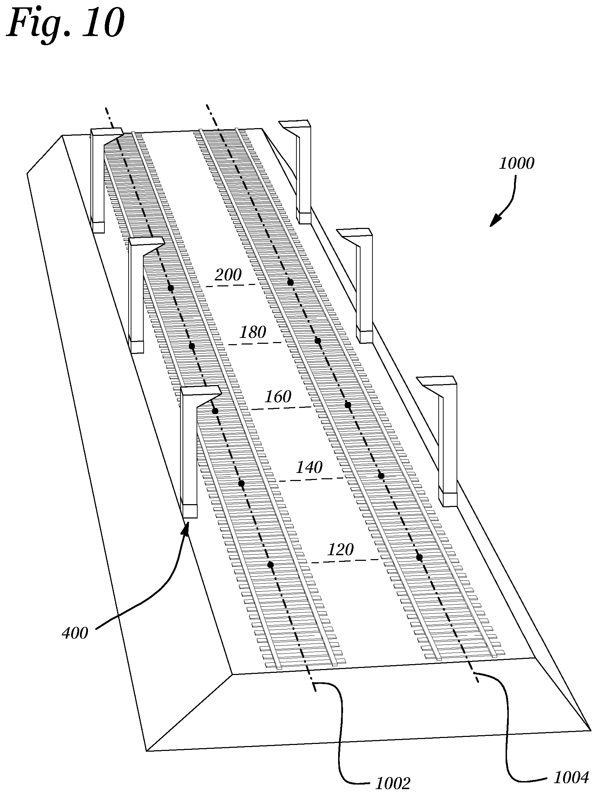

Fig. 10 shows a pair of railway tracks constructed by a method in accordance with the present disclosure.

### DETAILED DESCRIPTION

In a first aspect, the present disclosure provides a data format embodied on a medium, wherein the data format defines an alignment for a linear construction infrastructure. The data format comprises a series of points, each point defining a position on the alignment, wherein each point comprises:
(i) a horizontal geographic coordinate of the point;
(ii) a chainage number of the alignment at the point; and
(iii) a horizontal direction of the alignment at the point.

A data format where each point includes a chainage number, a horizontal geographic coordinate and a horizontal direction of alignment provides significant improvements in the efficiency of downstream computation in on-site construction. In particular, complex transition curves used to join non-curved element of an alignment, such as straight elements with elements with a constant curvature are computationally expensive to model on-site. The described data format avoids complex computation of a model of the entire complex curved element by equipment on-site during construction.

A chainage number indicates a distance along the alignment as measured from a chainage origin point, on the alignment.

In some examples, the horizontal geographic coordinate is recorded as a cartesian coordinate, comprising at least x and y coordinates.

In some examples, the horizontal direction can be defined by a numeric parameter. In some examples, the horizontal direction is defined by an angular distance from a fixed direction such as north, and/or an Azimuth.

In some examples, each point further comprises:
(iv) a horizontal curvature of the alignment at the point.

Advantageously, providing horizontal curvature of the alignment at each of the points further reduces computational load at the appliance on-site during construction.

In some examples, the horizontal curvature of the alignment is recorded as a numeric parameter such as a reciprocal value of the radius of curvature, and/or 1/radius of curvature.

In some examples, each point further comprises:
(iv) an elevation of the alignment at the point.

In some examples where the horizontal geographic coordinate is recorded as a cartesian coordinate, the cartesian coordinate comprises x, y, and z coordinates, where the z coordinate describes the elevation of point on the alignment as measured from sea level, and therefore the elevation of the alignment at the point.

In some examples, each point further comprises:
(iv) a vertical incline of the alignment at the point.

Provision of additional information such as the elevation of the point and the vertical incline of the alignment at the point further improve the efficiency of computing the position of a given element of the planned construction relative to a global coordinate system.

In some examples, the vertical incline of the alignment is a numeric parameter defining the angle of incline of the alignment.

In some examples, the alignment includes at least one portion that has a curvature which changes gradually along its length.

A curve that transitions from a straight element to a curved element may have a curvature that varies continuously along its length. Such a curve is known as a transition curve.

In some examples, the curvature of a transition curve increases continuously along its length. In some examples, the curvature of a transition curve decreases continuously along its length. In some examples, the curvature of a transition curve varies in a non-discontinuous manner along its length.

In some examples, a transition curve joins a straight element to another straight element.

A continuously changing curvature provided in a transition curve provides a stable transition from a straight element of the alignment to a curved element of the alignment, improving characteristics of the construction infrastructure.

In some examples, the series of points is determined based on each element of the alignment. In some examples, a minimum number of two points is required for each of the straight segments. In some examples, a minimum number of one chainage point per 5 meters is required for defining an arc, curve, or transition curve.

By defining points at set distances on curves and at the ends of straight elements, the accuracy of interpolation performed between the points during generation of a model is improved.

In some examples, the series of points is preferably evenly spaced along the alignment.

In some examples, the series of points is evenly spaced in each element of the alignment.

In some examples, the spacing of the series of points within an element of the alignment is determined based at least in part on the type of element.

In some examples, the spacing of the series of points within an element of the alignment is different to the spacing within a different element of the alignment.

Different spacings of points allow for efficient storage of information to define the path of the alignment for elements which have simple, non-complex shapes.

In some examples, the linear construction infrastructure is a road infrastructure, a rail infrastructure or a pipeline.

According to a second aspect of the present disclosure, there is provided a computer-implemented method of generating the data format as described above. The method comprises:
(i) receiving an initial alignment for the linear construction infrastructure, the initial alignment comprising a horizontal alignment, wherein the horizontal alignment comprises a series of two-dimensional elements viewed in a horizontal plane, wherein the horizontal alignment defines a respective chainage number at the start point and the end point of each two-dimensional element; and
(ii) generating the series of points for the data format comprising calculating for each point of a series of points along the length of the initial alignment: (a) the horizonal geographic coordinate of the point, (ii) the chainage number of the point and (iii) the horizontal direction of the point.

In some examples, the horizontal alignment defines a respective curvature (1/R) at the start point and the end point of each two-dimensional element. Preferably, the curvature is defined by storing a value representing the radius of curvature (R) at the start point of each two-dimensional element, and a corresponding value representing the radius of curvature at the end point of each two-dimensional element.

That is to say, in some examples one or more points comprise a value indicative of the horizontal curvature of the alignment, but not every data point need comprise such a value. For example, points lying on straight elements may not comprise a value indicative of a horizontal curvature of the alignment. In some examples, every point lying on a horizontal transition curve comprises a value indicative of horizontal curvature. In some examples, the first and last points lying on an element of curved element (i.e. an element with constant horizontal curvature) comprise a value indicative of the horizontal curvature of the curved element.

In some examples, generating the series of points for the data format further comprises calculating for each point of the series of points along the length of the initial alignment: (iv) a horizontal curvature of the alignment at the point.

In some examples, the initial alignment further comprises a vertical alignment, wherein the vertical alignment comprises a series of two-dimensional elements viewed in a vertical plane. The vertical alignment defines a respective chainage number at the start point and the end point of each two-dimensional element, wherein the horizontal alignment and vertical alignment together define a three-dimensional alignment. The generating the series of points for the data format further comprises calculating for each point of the series of points along the length of the initial alignment: (v) the elevation of the alignment at the point and/or (vi) the vertical incline of the alignment at the point.

In some examples, the two-dimensional elements can be straight lines, arcs, or transition curves.

In some examples, a pre-defined set of transition curves with differing pre-defined curve shapes can be used to construct an alignment.

Use of pre-determined transition curves simplifies the process of determining the path of an alignment.

In a third aspect of the present disclosure, there is provided a computer-implemented method of generating a model for a linear construction infrastructure. The method comprises generating a model which defines the linear construction infrastructure with reference to an alignment defined by the data format as described above.

In order to place infrastructure according to the alignment, a model defining the linear infrastructure may be used to determine the positions of various construction elements of the linear infrastructure during construction.

Construction elements should be understood as components of the linear infrastructure, such as formwork, locating foundations for masts, locating manholes and other construction elements.

Advantageously, the data format as described above allows use of as little as one point to create a model to determine placement of a particular construction element.

In a fourth aspect of the present disclosure, there is provided a computer-implemented method of providing a data format defining an alignment for a linear construction infrastructure from a first computer apparatus to a second computer apparatus, the method comprising:
(iii) generating at the first computer apparatus the data format as described above in relation to the first aspect; and
(iv) providing the data format to the second computer apparatus.

The data format can thereby be used to efficiently communicate an alignment from one location or computing device to another.

In some examples, the computer-implemented method further comprises:
(v) generating a model which defines the linear construction infrastructure with reference to the alignment defined by the data format; and
(vi) providing the model to the second computer apparatus.

The a model may thus be communicated from one computing device to another, for example a computing device may determine the model required for placement of a particular construction element, construct the model as needed and transmit that model to a computing device on the construction site for placement of the construction element.

In a fifth aspect of the present disclosure, there is provided a computer readable medium storing computer-executable instructions which, when executed, cause a computer system to perform the method as described above.

In a sixth aspect of the present disclosure, there is provided a computer system comprising a memory and a processor, wherein the system is configured to perform the method of any of aspects as described above.

In a seventh aspect of the present disclosure, there is provided a method of controlling a construction apparatus. The method comprises:
controlling the apparatus to carry out an operation at a position defined in relation to the alignment defined by the data format as described above.

In some examples, the operation may be excavating, filling, or compacting material.

In some examples, the operation may be setting out or placing a construction element.

In some examples, the operation may be setting out an asset to be constructed, such as formwork, locating foundations for masts, locating manholes and the like.

Advantageously, the above method achieves improvements in accuracy of placement of construction elements and locating assets.

In an eighth aspect of the present disclosure, there is provided a construction machine wherein the construction machine has a memory and a processor. The memory stores the data format of as described above and the construction machine is configured to perform the method as described in relation to the seventh aspect above.

In a ninth aspect of the present disclosure, there is provided a model of a linear construction infrastructure embodied on a medium. The model defines the linear construction infrastructure defined with reference to an alignment defined by the data format as described above.

In a tenth aspect of the present disclosure, there is provided a method of constructing a linear construction infrastructure. The method comprising:
(i) using the alignment defined by the data format as described above or the model as described above; and
(ii) constructing the linear construction infrastructure.

Advantageously, the above method achieves improvements in accuracy of construction of linear infrastructure.

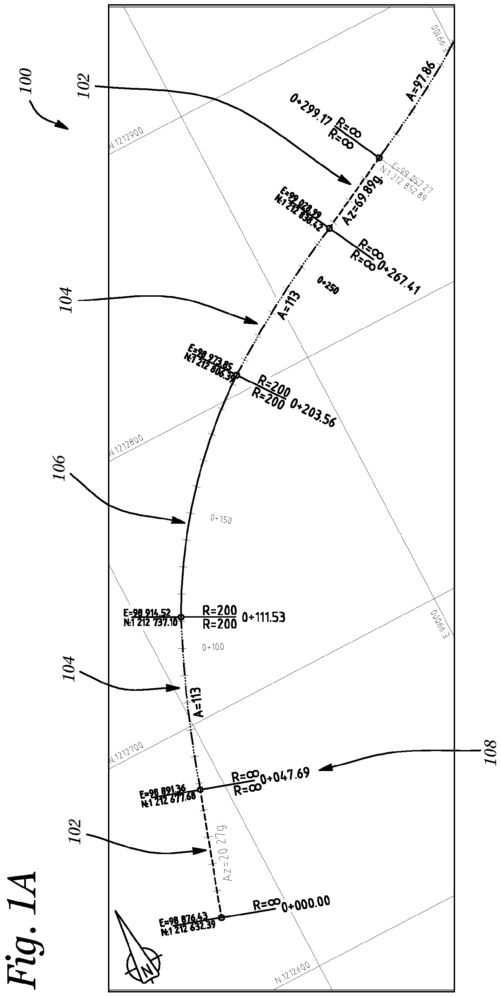

Referring now to the drawings, Fig. 1a shows an example of a horizontal alignment 100 viewed from above. The horizontal alignment 100 comprises a number of two-dimensional elements 102, 104, 106.

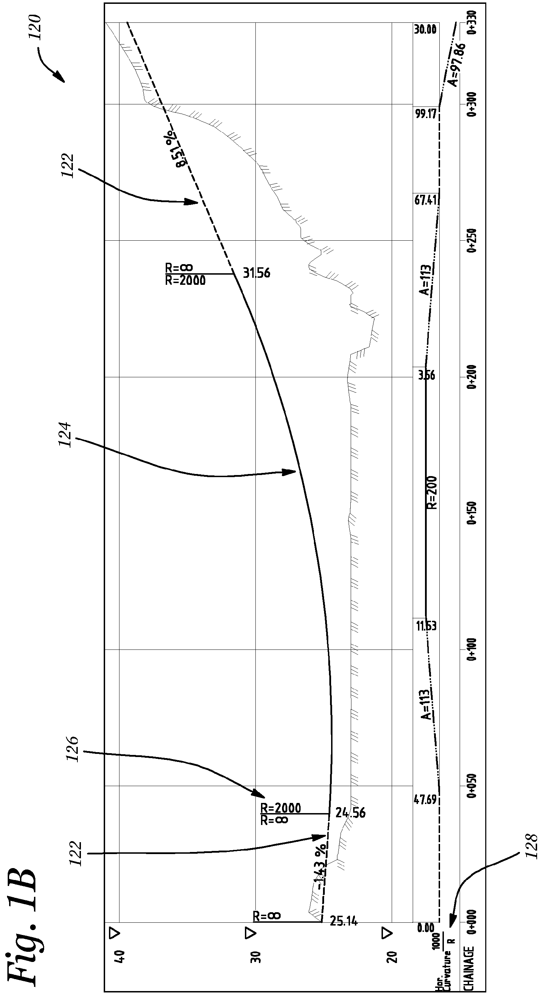

From left to right, the horizontal alignment 100 comprises a 'straight' element 102 with no horizontal curvature, followed by a 'transition curve' element 104. The transition curve element 104 has a curvature which is a function of the chainage length. In the example of Fig. 1, the transition curve 104 element follows the path of a clothoid where the curvature at each point of the two-dimensional element 104 is proportional to the length of the two-dimensional element at that point. The transition curve element 104 is determined based upon the curvature of a constant curvature element 106 which follows the transition curve element 104.

In the construction of linear infrastructure such as railways or roads, the transverse acceleration of vehicles which will traverse the linear infrastructure must be considered at a range of speeds. Transitions between linear and curved sections of the infrastructure must be determined which will allow for a stable transition from no transverse or lateral acceleration to the maximum required (for example, when the infrastructure has a constant non-zero curvature) and then back to zero when the infrastructure returns to a straight, non-curved path.

Constructing transition elements 104 of an infrastructure to follow a clothoid curve as a transition between straight elements 102 and constant curvature elements 106 provides a linearly increasing transverse acceleration to a vehicle traversing the infrastructure at constant speed.

Other transition curves may be used, such as non-clothoid spirals.

Constant curvature two-dimensional element 106 follows a path such that it has a constant curvature. At each point of the constant curvature element 106, the curvature is the same.

The constant curvature two-dimensional element 106 is connected to a further transition curve element 104. A constant curvature two-dimensional element 106 of a horizontal curvature cannot be joined directly to a straight element 102 without a transition curve element 104 in between, unless the infrastructure is designed for low speeds.

The further transition curve element 104 joins to a further straight element 102, completing a direction change in the horizontal alignment 100 representing the path of a linear infrastructure.

Fig. 1a shows each of the two-dimensional elements 102, 104, 106 with markers 108 at the start and end of each element. These markers indicate the radius of curvature, R, of the points immediately preceding and following each marker 108. Each of the two-dimensional elements 102, 104, 106, are labelled with their length L. The transition curve elements 104 are additionally labelled with a constant, A, used in computation of the clothoid which defines their path.

Fig. 1b shows a vertical alignment 120 which corresponds to the horizontal alignment 100 of Fig. 1a.

The vertical alignment 120 comprises a two-dimensional straight element 122 with no vertical curvature which is connected to a two-dimensional constant curvature element 124 with a constant vertical curvature. Unlike the horizontal alignment 100, transition curves are not required for joining straight elements 122 with curved elements 124.

Markers 126 are shown at the start and end of each of the two-dimensional elements 122, 124, which show the curvature of the point immediately before and after each marker 126.

Below the vertical alignment 120 is shown the corresponding horizontal curvature 128 of the horizontal alignment 100 at the corresponding chainage lengths of the depicted vertical alignment 120.

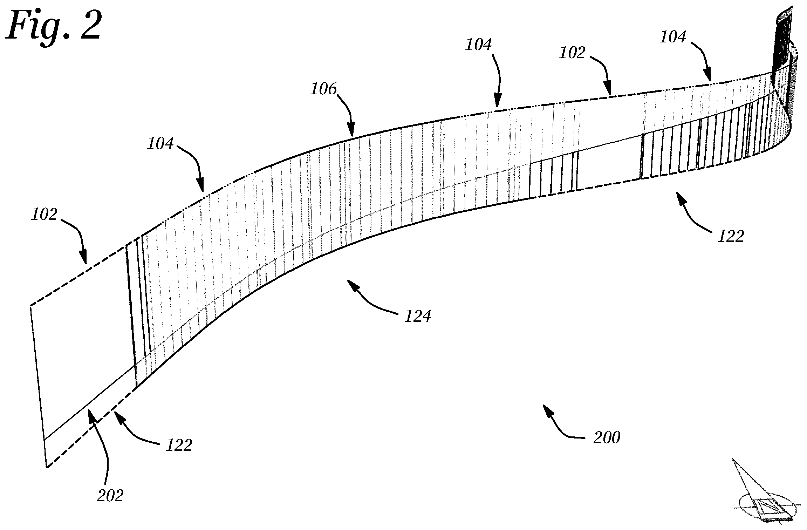

Fig. 2 shows an example of a three-dimensional alignment 200, corresponding to the combination of the horizontal alignment 100 of Fig. 1a and the vertical alignment 120 of Fig. 1b.

The path of the alignment 200 is shown by path 202. Above the path 202 are indicated the horizontal alignment 100 two-dimensional elements 102, 104, 106, and below the path are indicated the vertical alignment 120 two-dimensional elements 122, 124.

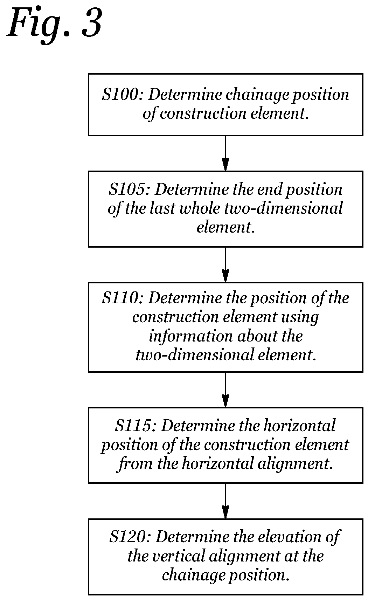

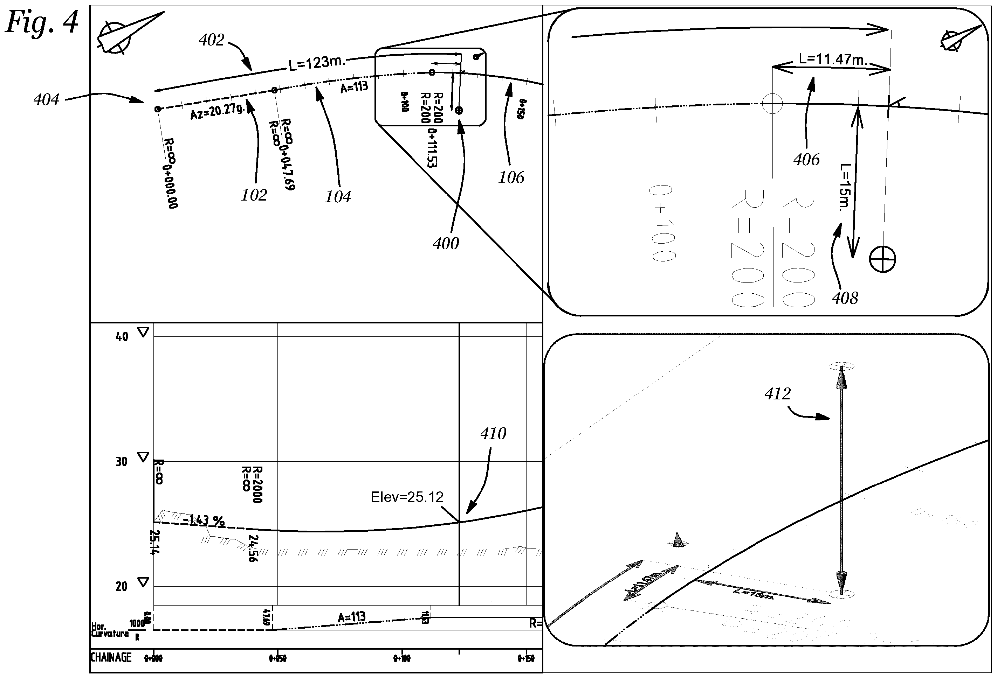

Fig. 3 shows an example process for determining the location of a construction element as established in the art. Fig. 4 shows an illustration of the process. For the ease of description, the following passages refer to each of Fig. 3 and Fig. 4.

At step S100, the position of the construction element 400 is determined relative to the horizontal alignment 100. The chainage distance 402 of the construction element from a chainage origin 404 is determined. The chainage origin 404 is an origin point for the alignment 100, from which the distance along the alignment is measured in chainage values. The distance from the chainage origin 404 is measured along the path of the horizontal alignment 100.

At step S105, each two-dimensional element 102, 104 of the horizontal alignment 100 between the chainage origin 404 and the chainage position of the construction element 400 is identified. In order from the chainage origin 404, the position of the end of the first horizontal two-dimensional element 102, 104, is computed based on the curvature and length of that two-dimensional element 102, 104. This is repeated for each two-dimensional element 102, 104 which falls entirely within the chainage distance 402 of the construction element 400 from the chainage origin 404 until the chainage position of the construction element 400 lies within a two-dimensional element 106. The remaining chainage length 406 to the construction element 400 after the end of the last whole two-dimensional element 104 is computed.

At step S110, the curvature of the remaining two-dimensional element 106 is used along with the remaining chainage length 406 to determine the position of the horizontal alignment 100 at the chainage position of the construction element 400.

At step S115, the horizontal distance 408 of the construction element 400 from the alignment 100 is determined and the horizontal position of the construction element 400 determined.

At step S120, the vertical position 410 of the vertical alignment 120 at the determined chainage position of the construction element 400 is determined to establish the elevation 412 of the construction element 400 to determine the final position of the construction element 400.

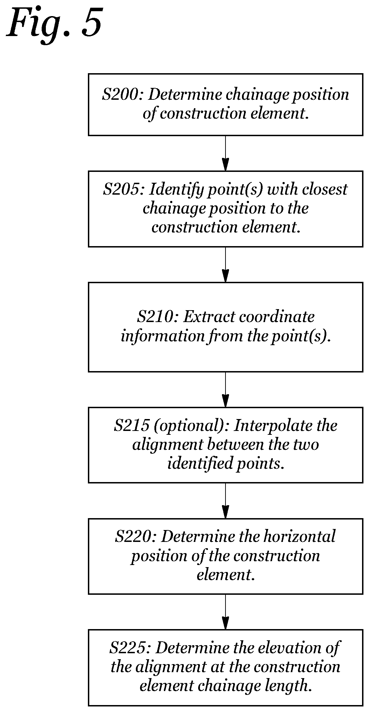

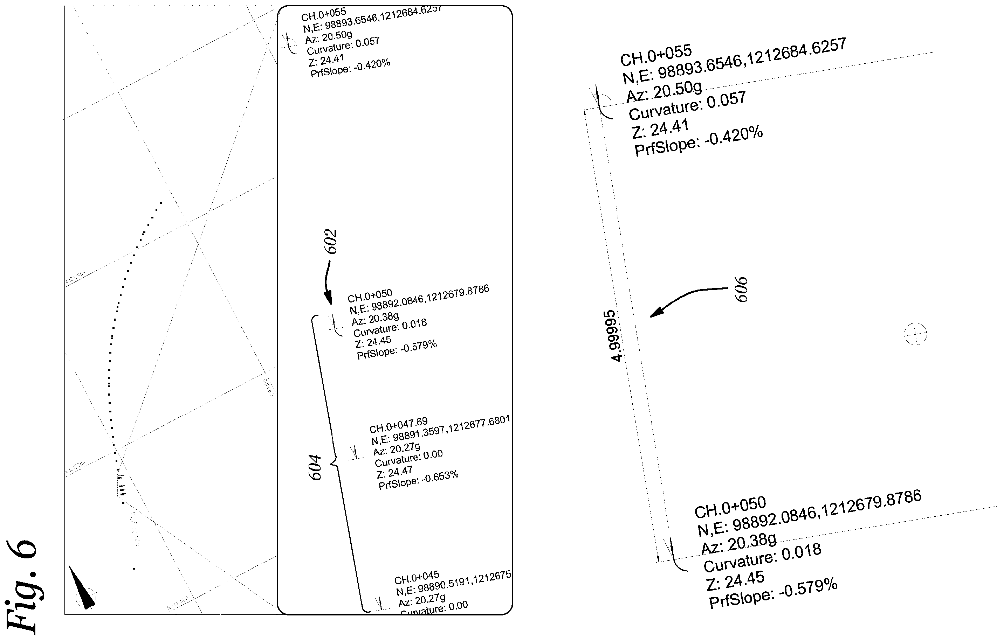

Fig. 5 shows an example process for determining the location of a construction element using the data format in accordance with the present disclosure. Fig. 6 shows an illustration of the process. For the ease of description, the following passages refer to each of Fig. 5 and Fig. 6.

At step S200 the position of the construction element 400 is determined relative to the horizontal alignment 100. The chainage distance 402 of the construction element from a chainage origin 404 is determined.

At step S205, at least one closest point 602 of a series of points 604 defining the alignment is identified. If the chainage position of the construction element 400 lies between two points 602, both points 602 are identified.

At step S210, location information is extracted from the one or more points to determine the location of the points, the curvature of the alignment at each of the points, and the direction of the alignment at the points.

If the chainage position, of the construction element 440 lies between two points, then optional step S215 is performed.

At step S215, an intermediate path 606 of the alignment is interpolated between the two closest points to the chainage position of the construction element 440.

At step S220, the horizontal distance of the construction element from the horizontal alignment is determined to compute the horizontal position of the construction element. The horizontal position of the construction element 400 is determined by using either a single point 602 as the position of the horizontal alignment, or by using a closest position on the intermediate path 606 to the construction element 400.

At step S225 the elevation of the alignment is extracted from either the closest point, or from the intermediate path 606 between the closest two points to determine the elevation of the construction element.

With further reference to Fig. 6, a data format in accordance with the present disclosure comprises a series of points 604 which define an alignment 300 for construction of linear infrastructure. Each of the points 602 represents a location in three dimensions on the alignment. That is to say, each of the points 602 in the series of points 604 relates to a position on the alignment 300 and also a position relative to a local coordinate system, for example, at a construction site.

Each of the points 602 of the series of points 604 comprises information which indicates the geographical location of the point 602 in real space. Typically, the position is recorded using geographical coordinates, N, E, relative to a local coordinate system and elevation, Z, relative to sea level. Because each of the points 602 are on the alignment, information about the point 602 is also information about the alignment 300.

Each of the points 602 further comprises information about the alignment 300 at that position. Each of the points 602 comprises a chainage length CH, defining the distance from a chainage origin of the alignment 300 to the location of the point 602, in a chainage value. At least one point 602 will define the chainage origin and have a chainage length of zero. The chainage origin is an origin location for the alignment 300, from which the distance along the alignment 300 is measured in chainage values. The distance from the chainage origin to a point is measured along the path of the alignment 300.

Each of the points 602 further comprises information about the curvature of the alignment at the location of the point, and a value Az representing the angle subtended between an azimuth and the direction of the alignment as it increases in chainage value from that point. An azimuth may be selected direction, for example due North.

Each of the points further comprises a value that indicates the vertical slope PrfSlope of the alignment at the location of the point. The vertical slope may be expressed as a gradient percentage.

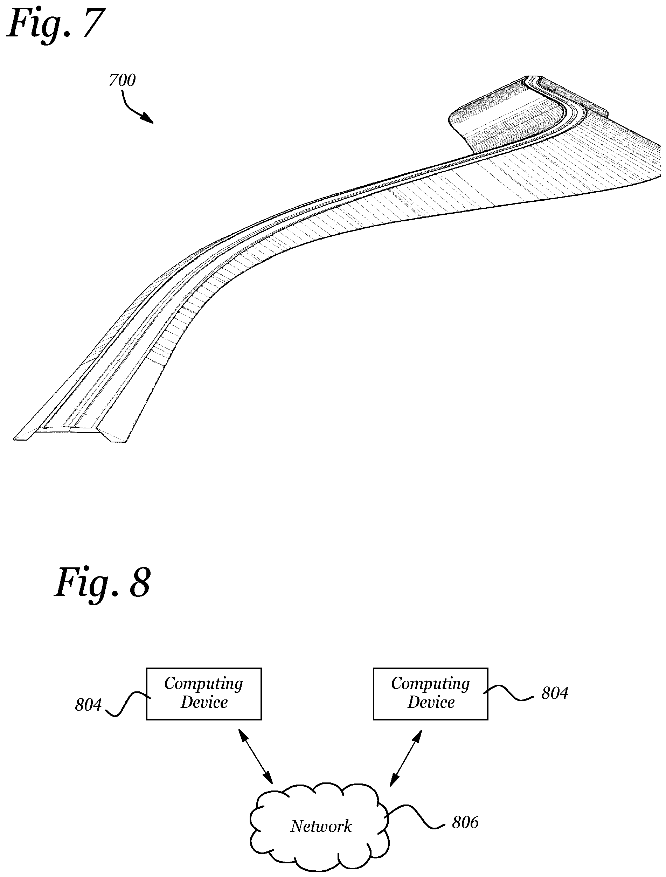

Fig. 7 shows an example of a computer model of a linear infrastructure created in accordance with an alignment 200 represented by the data format of the present disclosure.

Fig. 8 shows an example of a computer network in accordance with the present disclosure. A first computing device 802 is shown in communication with a second computing device 804 via a network 806.

The computing device 802 is operable to generate the data format in accordance with the present disclosure, and transmit the data format to the second computing device 804 via the network 806.

Fig. 9a shows an example of a construction machine 902 to which an alignment 300 may be provided using the data format in accordance with the present disclosure.

Fig. 9b shows an example of a control system 904 configured to control a construction machine 902 comprising a processor 906, memory 908, communication interface 910, user interface 912, control interface 914 and bus 916. The bus 916 is configured to allow communication between the individual elements of the construction machine 902.

The construction machine 902 is operable to store the data format of the present disclosure in memory 906 and carry out an operation such as constructing linear infrastructure according to the alignment 300 stored in the data format. The construction machine 902 is further configured to perform the operation automatically.

Fig. 10 shows a railway 1000 as an example of a completed linear infrastructure. Shown on the example is an alignment 1002 and a duplicate alignment 1004 parallel to the alignment 1002. Further shown are examples of construction elements 400, as gantries.

The data format may be embodied on a medium, which is typically a computer-readable medium. The data format may be provided to an apparatus, such as a computer, on the computer-readable medium. The computer-readable medium may be transitory or non-transitory. The computer-readable medium could be, for example, an electronic, magnetic, optical, electromagnetic, infrared, or semiconductor system, or a propagation medium for data transmission, for example for downloading the code over the Internet. Alternatively, the computer-readable medium could take the form of a physical computer-readable medium such as semiconductor or solid-state memory, magnetic tape, a removable computer diskette, a random-access memory (RAM), a read-only memory (ROM), a rigid magnetic disc, or an optical disk, such as a CD-ROM, CD-R/W or DVD.

The various methods described herein may be implemented by a computer program. The computer program may include computer code arranged to instruct a computer to perform the functions of one or more of the various methods described herein. The computer program and/or the code for performing such methods may be provided to an apparatus, such as a computer, on a computer-readable medium or, more generally, a computer program product. The computer-readable medium may be transitory or non-transitory. The computer-readable medium could be, for example, an electronic, magnetic, optical, electromagnetic, infrared, or semiconductor system, or a propagation medium for data transmission, for example for downloading the computer program and/or the code over the Internet. Alternatively, the computer-readable medium could take the form of a physical computer-readable medium such as semiconductor or solid-state memory, magnetic tape, a removable computer diskette, a random-access memory (RAM), a read-only memory (ROM), a rigid magnetic disc, or an optical disk, such as a CD-ROM, CD-R/W or DVD. A computer-readable medium on which computer code for performing such methods as set out in the present disclosure may comprise one or more computer-readable media as set out above.

The above embodiments of the present disclosure are described by way of example only and are not intended to limit the scope of the appended claims. Various modifications are possible within the scope of the appended claims and will be readily apparent to the skilled person in the art. Furthermore, it is intended that any combination of non-mutually exclusive features described herein can be made.

The present disclosure also comprises the following numbered clauses:
1. A data format embodied on a medium, wherein the data format defines an alignment for a linear construction infrastructure, wherein the data format comprises a series of points, each point defining a position on the alignment, wherein each point comprises:
   (i) a horizontal geographic coordinate of the point;
   (ii) a chainage number of the alignment at the point; and
   (iii) a horizontal direction of the alignment at the point.
2. The data format of clause 1, wherein each point further comprises:
   (iv) a horizontal curvature of the alignment at the point.
3. The data format of any preceding clause, wherein each point further comprises:
   (iv) an elevation of the alignment at the point.
4. The data format of any preceding clause, wherein each point further comprises:
   (iv) a vertical incline of the alignment at the point.
5. The data format of any preceding clause, wherein the alignment includes at least one portion that has a curvature which changes gradually along its length.
6. The data format of any preceding clause, wherein the linear construction infrastructure is a road infrastructure, a rail infrastructure or a pipeline.
7. A computer-implemented method of generating the data format of any of clauses 1 to 6, the method comprising:
   (i) receiving an initial alignment for the linear construction infrastructure, the initial alignment comprising a horizontal alignment, wherein the horizontal alignment comprises a series of two-dimensional elements viewed in a horizontal plane, wherein the horizontal alignment defines a respective chainage number at the start point and the end point of each two-dimensional element; and
   (ii) generating the series of points for the data format comprising calculating for each point of a series of points along the length of the initial alignment: (i) the horizonal geographic coordinate of the point, (ii) the chainage number of the point and (iii) the horizontal direction of the point.
8. The method of clause 7, wherein generating the series of points for the data format further comprises calculating for each point of the series of points along the length of the initial alignment: (iv) a horizontal curvature of the alignment at the point.
9. The method of clause 7 or clause 8, wherein initial alignment further comprises a vertical alignment, wherein the vertical alignment comprises a series of two-dimensional elements viewed in a vertical plane, wherein the vertical alignment defines a respective chainage number at the start point and the end point of each two-dimensional element, wherein the horizontal alignment and vertical alignment together define a three-dimensional alignment, wherein the generating the series of points for the data format further comprises calculating for each point of the series of points along the length of the initial alignment: (v) the elevation of the alignment at the point and/or (vi) the vertical incline of the alignment at the point.
10. A computer-implemented method of generating a model for a linear construction infrastructure, the method comprising generating a model which defines the linear construction infrastructure with reference to an alignment defined by the data format of any of clauses 1 to 6.
11. A computer-implemented method of providing a data format defining an alignment for a linear construction infrastructure from a first computer apparatus to a second computer apparatus, the method comprising:
   (i) generating at the first computer apparatus the data format of any of clauses 1 to 6; and
   (ii) providing the data format to the second computer apparatus.
12. The computer-implemented method of clause 11, further comprising:
   (i) generating a model which defines the linear construction infrastructure with reference to the alignment defined by the data format; and
   (ii) providing the model to the second computer apparatus.
13. A computer readable medium storing computer-executable instructions which, when executed, cause a computer system to perform the method of any of clauses to 7 to 12.
14. A computer system comprising a memory and a processor, wherein the system is configured to perform the method of any of clauses 7 to 12.
15. A method of controlling a construction machine, the method comprising:
   controlling the apparatus to carry out an operation at a position defined in relation to the alignment defined by the data format of any of clauses 1 to 6.
16. The method according to clause 15, wherein the construction machine has a memory and a processor, wherein the memory stores the data format and the method is performed automatically by the construction machine.
17. A construction machine wherein the construction machine has a memory and a processor wherein the memory stores the data format of any of clauses 1 to 6 and the construction machine is configured to perform the method of clause 15 automatically.
18. A model of a linear construction infrastructure embodied on a medium, wherein the model defines the linear construction infrastructure defined with reference to an alignment defined by the data format of any of clauses 1 to 6.
19. A method of constructing a linear construction infrastructure, the method comprising:
   (i) using the alignment defined by the data format of any of clauses 1 to 6 or the model of clause 18; and
   (ii) constructing the linear construction infrastructure.

## Claims

1. A data format embodied on a medium, wherein the data format defines an alignment for a linear construction infrastructure, wherein the data format comprises a series of points, each point defining a position on the alignment, wherein each point comprises:
(i) a horizontal geographic coordinate of the point;
(ii) a chainage number of the alignment at the point; and
(iii) a horizontal direction of the alignment at the point.

2. The data format of claim 1, wherein each point further comprises one or more of:
(iv) a horizontal curvature of the alignment at the point;
(v) an elevation of the alignment at the point; and/or
(vi) a vertical incline of the alignment at the point.

3. The data format of any preceding claim, wherein the alignment includes at least one portion that has a curvature which changes gradually along its length.

4. The data format of any preceding claim, wherein the linear construction infrastructure is a road infrastructure, a rail infrastructure or a pipeline.

5. A computer-implemented method of generating the data format of any of claims 1 to 4, the method comprising:
(i) receiving an initial alignment for the linear construction infrastructure, the initial alignment comprising a horizontal alignment, wherein the horizontal alignment comprises a series of two-dimensional elements viewed in a horizontal plane, wherein the horizontal alignment defines a respective chainage number at the start point and the end point of each two-dimensional element; and
generating the series of points for the data format comprising calculating for each point of a series of points along the length of the initial alignment: (i) the horizonal geographic coordinate of the point, (ii) the chainage number of the point and (iii) the horizontal direction of the point; and
optionally wherein generating the series of points for the data format further comprises calculating for each point of the series of points along the length of the initial alignment: (iv) a horizontal curvature of the alignment at the point.

6. The method of claim 5, wherein initial alignment further comprises a vertical alignment, wherein the vertical alignment comprises a series of two-dimensional elements viewed in a vertical plane, wherein the vertical alignment defines a respective chainage number at the start point and the end point of each two-dimensional element, wherein the horizontal alignment and vertical alignment together define a three-dimensional alignment, wherein the generating the series of points for the data format further comprises calculating for each point of the series of points along the length of the initial alignment: (v) the elevation of the alignment at the point and/or (vi) the vertical incline of the alignment at the point.

7. A computer-implemented method of generating a model for a linear construction infrastructure, the method comprising generating a model which defines the linear construction infrastructure with reference to an alignment defined by the data format of any of claims 1 to 4.

8. A computer-implemented method of providing a data format defining an alignment for a linear construction infrastructure from a first computer apparatus to a second computer apparatus, the method comprising:
(i) generating at the first computer apparatus the data format of any of claims 1 to 4; and
(ii) providing the data format to the second computer apparatus.

9. The computer-implemented method of claim 8, further comprising:
(i) generating a model which defines the linear construction infrastructure with reference to the alignment defined by the data format; and
(ii) providing the model to the second computer apparatus.

10. A computer readable medium storing computer-executable instructions which, when executed, cause a computer system to perform the method of any of claims to 7 to 12.

11. A computer system comprising a memory and a processor, wherein the system is configured to perform the method of any of claims 5 to 10.

12. A method of controlling a construction machine, the method comprising:
controlling the apparatus to carry out an operation at a position defined in relation to the alignment defined by the data format of any of claims 1 to 4, and optionally wherein the construction machine has a memory and a processor, wherein the memory stores the data format and the method is performed automatically by the construction machine.

13. A construction machine wherein the construction machine has a memory and a processor wherein the memory stores the data format of any of claims 1 to 4 and the construction machine is configured to perform the method of claim 12 automatically.

14. A model of a linear construction infrastructure embodied on a medium, wherein the model defines the linear construction infrastructure defined with reference to an alignment defined by the data format of any of claims 1 to 4.

15. A method of constructing a linear construction infrastructure, the method comprising:
(i) using the alignment defined by the data format of any of claims 1 to 4 or the model of claim 14; and
(ii) constructing the linear construction infrastructure.
